# EUROPÄISCHE PATENTANMELDUNG

(11) **EP 2 741 342 A2**
(43) Veröffentlichungstag der Anmeldung: **11.06.2014**
(21) Anmeldenummer: 13005607.0
(22) Anmeldetag: 02.12.2013
(51) Int. Cl.: H01L 43/06

(54) **Magnetfeldsensor**

(30) Priorität: 10.12.2012 DE 102012024062
(71) Anmelder: Micronas GmbH, 79108 Freiburg (DE)
(72) Erfinder: Jörg, Franke, 79117 Freiburg (DE)
(74) Vertreter: Koch Müller Patentanwaltsgesellschaft mbH

(57) **Zusammenfassung**

Magnetfeldsensor (10) mit einem Träger (20) mit einer Oberseite und einer Unterseite, wobei an der Oberseite des Trägers eine Hallplatte (30) vorhanden ist und die Hallplatte eine kohlenstoffhaltige Schicht umfasst.

## Beschreibung

Die Erfindung betrifft ein Magnetfeldsensor gemäß dem Oberbegriff des Patentanspruchs 1.

Aus der DE 202 11 518 U1 ist ein Träger mit einer Hallplatte bekannt. Des Weiteren sind der US 2011 / 0037464 A1 kohlenstoffhaltige Hallplatten und aus der US 5 162 885 Hallplatten aus III-V Elementen bekannt. Andere Hallplatten sind aus der US 5 859 624 und der DE10 2005 051 306 A1 bekannt.

Vor diesem Hintergrund besteht die Aufgabe der Erfindung darin, eine Vorrichtung anzugeben, die den Stand der Technik weiterbildet.

Die Aufgabe wird durch einen Magnetfeldsensor mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Magnetfeldsensor mit einem Träger mit einer Oberseite und einer Unterseite bereitgestellt, wobei an der Oberseite des Trägers eine Hallplatte vorgesehen ist und die Hallplatte eine kohlenstoffhaltige Schicht umfasst. Es sei angemerkt, dass die kohlenstoffhaltige Schicht, welche sich in einer Ausführungsform auch aus mehreren Schichten zusammensetzt, ein Bestandteil der Hallplatte bildet und die kohlenstoffhaltige Schicht eine Hallspannung erzeugt. Es versteht sich, dass eine Hallplatte eine Hallspannung erzeugt, sofern die Hallplatte Betriebsstrom durchflossen ist und ein Anteil des magnetischen Flusses die Oberfläche der Hallplatte senkrecht durchdringt.

Ein Vorteil des erfindungsgemäßen Magnetfeldsensors ist es, dass sich eine kohlenstoffhaltige Schicht einfach und kostengünstig herzustellen lässt. Untersuchungen haben gezeigt, dass sich aufgrund der hohen Beweglichkeit der Ladungsträger in den kohlenstoffhaltigen Schichten auch bei kleinen magnetischen Flüssen eine Hallspannung ergibt und sich ein empfindlicher Magnetfeldsensor herstellen lässt.

In einer Weiterbildung ist die kohlenstoffhaltige Schicht als Hallplatte ausgebildet, d. h. die Hallplatte besteht ausschließlich aus der kohlenstoffhaltigen Schicht. Vorzugsweise ist das Verhältnis der Größe der lateralen Ausdehnung der Schicht zu der Dicke der Schicht größer als 50.

In einer anderen Ausführungsform ist die kohlenstoffhaltige Schicht als zweidimensionale Schicht ausgebildet, so dass ein Stromfluss im Wesentlichen nur parallel zu der Schichtebene stattfindet. Untersuchungen haben gezeigt, dass eine defektarme Ausbildung mit einer hohen Ladungsträgerbeweglichkeit parallel zu der Ebene der kohlenstoffhaltigen Schicht eine besonders hohe Hallspannung bedingt. Vorzugsweise umfasst die zweidimensionale Schicht einen Bereich zwischen 1 und 20 Atomlagen, wobei der Ladungsträgertransport in einer Atomlage oder in mehreren Atomlagen erfolgt. Höchst vorzugsweise umfasst die zweidimensionale Schicht genau 1 Atomlage. Bevorzugt findet der Ladungsträgertransport nur in einer Atomlage statt.

Bevorzugt ist, die Hallplatte mit einer Steuereinheit elektrisch zu verschalten, wobei in einer besonders bevorzugten Ausführungsform die Steuereinheit mit auf dem Träger der Hallplatte angeordnet ist. Des Weiteren ist es bevorzugt die Steuereinheit und die Hallplatte in einem gemeinsamen Gehäuse anzuordnen. Bevorzugt ist, dass der Träger als Halbleitersubstrat und insbesondere als Siliziumsubstrat ausgebildet ist. Vorteilhaft bei einem Siliziumsubstrat ist, dass die Steuereinheit als integrierte Schaltung innerhalb des Substrates ausgebildet ist. Hierdurch ist die Steuereinheit mit dem Träger, d. h. dem Siliziumsubstrat, monolithisch integriert. Des Weiteren ist die Hallplatte vorzugsweise oberhalb der Passivierungsschicht des Siliziumsubstrats ausgebildet.

In einer Weiterbildung sind auf dem Träger zwei Hallplatten oder drei Hallplatten vorgesehen, wobei die Hallplatten vorzugsweise orthogonal zueinander angeordnet sind. Es ist bevorzugt, eine Hallplatte parallel zu der Oberseite des Trägers auszubilden.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Querschnittsansicht auf eine erste erfindungsgemäße Ausführungsform eines Magnetfeldsensors,
- Figur 2: eine Draufsicht auf die erste erfindungsgemäße Ausführungsform, dargestellt in der Abbildung der Figur 1,
- Figur 3: eine Draufsicht auf eine erste Ausführungsform einer Hallplatte,
- Figur 4: eine Draufsicht auf eine zweite Ausführungsform einer Hallplatte,
- Figur 5: eine Draufsicht auf einen dreidimensionalen Hallsensor.

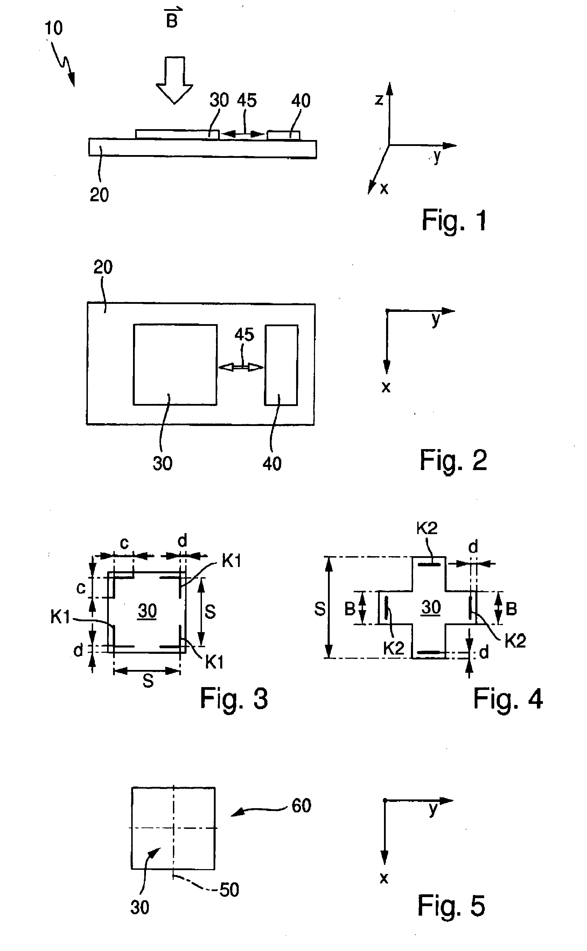

Die Abbildung der Figur 1 zeigt eine Querschnittsansicht einer ersten Ausführungsform auf, aufweisend einen Magnetfeldsensor 10 mit einem Träger 20 mit einer Oberseite 24 und einer Unterseite 28, wobei an der Oberseite 24 des Trägers 20 eine Hallplatte 30 vorgesehen ist. Aus Gründen der Übersichtlichkeit ist ein kartesisches Koordinatensystem eingezeichnet. Die Hallplatte 30 umfasst eine kohlenstoffhaltige Schicht und ist in parallel zu der x-y-Ebene ausgebildet. Es ist bevorzugt die gesamte Hallplatte 30 aus der kohlenstoffhaltigen Schicht auszubilden. Auf der Oberseite 24 des Trägers 20 ist eine Steuereinheit 40 angeordnet. Die Steuereinheit 40 ist mit der Hallplatte 30 elektrisch verschaltet und stellt den Betriebsstrom für die Hallplatte 30 mittels einer Verbindung 45 zur Verfügung. Des Weiteren liegt die Hallspannung der Hallplatte 30 mittels der Verbindung 45 an der Steuereinheit 40 an. Die Hallplatte 30 wird von einem Magnetfeld B senkrecht zu der Ebene der Hallplatte 30 durchdrungen.

In einer nicht dargestellten Ausführungsform sind die Steuereinheit 40 und die Hallplatte 30 in einem gemeinsamen Gehäuse angeordnet. Des Weiteren ist in einer ebenfalls nicht dargestellten Ausführungsform die kohlenstoffhaltige Schicht besonders dünn, als sogenannte 2-Dimensionale Schicht, ausgeführt. Hierdurch findet der Stromfluss im Wesentlichen nur parallel zu der Schichtebene statt.

In der Abbildung der Figur 2 ist eine Draufsicht auf die erste erfindungsgemäße Ausführungsform, dargestellt in der Abbildung der Figur 1 abgebildet. Im Folgenden werden nur die Unterschiede zu der Abbildung der Figur 1 erläutert. Die Hallplatte 30 weist an allen vier Rändern elektrische Anschlusskontakte auf. Die Anschlusskontakte sind jeweils mit der Steuereinheit 40 verschaltet. Die Steuereinheit 40 prägt mittels zwei Anschlusskontakten einen Betriebsstrom ein und nimmt mit den beiden verbleibenden Anschlusskontakten die Hallspannung ab.

In der Abbildung der Figur 3 ist eine Draufsicht auf eine erste Ausführungsform einer Hallplatte 30 dargestellt. Im Folgenden werden nur die Unterschiede zu den vorangegangenen Ausführungsformen erläutert. Aus Gründer der Übersichtlichkeit sind der Träger 20 und die Steuereinheit 40 nicht dargestellt. Die Hallplatte 30 ist als quadratische Platte ausgeführt. Die quadratische Platte weist eine Kantenlänge S auf. In allen vier Ecken der Platte sind Kontaktwinkel K1 mit einem Abstand d zu dem jeweiligen Rand der Platte angeordnet. Die Kontaktwinkel K1 weisen jeweils zwei gleich lange Schenkel mit einer Länge K1 auf und sind elektrisch mittels der Verbindung 45 mit der Steuereinheit 40 verschaltet - nicht dargestellt.

In der Abbildung der Figur 4 ist eine Draufsicht auf eine zweite Ausführungsform einer Hallplatte 30 dargestellt. Im Folgenden werden nur die Unterschiede zu den vorangegangenen Ausführungsformen erläutert. Aus Gründer der Übersichtlichkeit sind der Träger 20 und die Steuereinheit 40 nicht dargestellt. Hierbei ist die Hallplatte 30 als Kreuz mit einer Gesamtlänge S und mit vier zueinander symmetrisch ausgebildeten Schenkeln ausgebildet. Jeder Schenkel weist eine Breite B auf. An dem jeweiligen äußeren Ende eines jeden Schenkel des Kreuzes ist ein Kontaktstreifen K2 mit einer Breite B und dem Abstand d zu dem Rand angeordnet. In der jeweiligen Längserstreckung liegt der Kontaktstreifen K2 parallel zu dem äußeren Rand des jeweiligen Schenkels. Die vier Kontaktstreifen K2 sind elektrisch mittels der Verbindung 45 mit der Steuereinheit 40 verschaltet - nicht dargestellt.

In der Abbildung der Figur 5 ist eine Draufsicht auf einen dreidimensionalen Hallsensor dargestellt. Im Folgenden werden nur die Unterschiede zu den vorangegangenen Ausführungsformen erläutert. Aus Gründer der Übersichtlichkeit sind der Träger 20 und die Steuereinheit 40 nicht dargestellt.

Neben der parallel zu der x-y-Ebene ausgebildeten Hallplatte 30, sind eine weitere parallel zu der x-z-Ebene ausgebildete Hallplatte 50 und eine zusätzllche parallel zu der y-z-Ebene ausgebildete Hallplatte 60 vorgesehen. Indem die Hallplatten 30, 50 und 60 orthogonal zueinander angeordnet sind lässt sich ein Magnetfeld in allen 3 Raumrichtungen erfassen.

## Patentansprüche

1. Magnetfeldsensor (10) mit,
- einem Träger (20) mit einer Oberseite (24) und einer Unterseite (28), wobei
- an der Oberseite (24) des Trägers (20) eine Hallplatte (30) vorgesehen ist,
**dadurch gekennzeichnet, dass**
der Träger (20) als Siliziumsubstrat ausgebildet ist und in dem Siliziumsubstrat eine Steuereinheit (40) monolithisch integriert ist und die Hallplatte (30) eine kohlenstoffhaltige Schicht umfasst und die Hallplatte (30) oberhalb der Passivierungsschicht des Siliziumsubstrates ausgebildet ist und die Hallplatte (30) mit der Steuereinheit (40) elektrisch verschaltet ist und die Steuereinheit (40) und die Hallplatte (30) in einem gemeinsamen Gehäuse angeordnet sind.

2. Magnetfeldsensor (10) nach Anspruch 1, **dadurch gekennzeichnet, dass** die kohlenstoffhaltige Schicht als Hallplatte (30) ausgebildet ist.

3. Magnetfeldsensor (10) nach Anspruch 1 oder Anspruch 2, **dadurch gekennzeichnet, dass** kohlenstoffhaltige Schicht als zweidimensionale Schicht ausgebildet ist, so dass ein Stromfluss im Wesentlichen nur parallel zu der Schichtebene stattfindet.

4. Magnetfeldsensor (10) nach einem der vorangegangenen Ansprüche, **dadurch gekennzeichnet, dass** auf dem Träger (20) zwei Hallplatten (30, 50, 60) oder drei Hallplatten (30, 50, 60) vorgesehen sind.

5. Magnetfeldsensor (10) nach Anspruch 4, **dadurch gekennzeichnet, dass** die Hallplatten (30, 50, 60) orthogonal zueinander angeordnet sind.
